# EUROPEAN PATENT SPECIFICATION

(11) **EP 3 367 573 B1**
(45) Date of publication and mention of the grant of the patent: **14.09.2022**
(21) Application number: 17158444.4
(22) Date of filing: 28.02.2017
(51) Int. Cl.: H03M 3/00

(54) **DELTA-SIGMA ANALOG-TO-DIGITAL CONVERTER**
DELTA-SIGMA-ANALOG-DIGITAL-WANDLER
CONVERTISSEUR ANALOGIQUE-NUMÉRIQUE DELTA-SIGMA

(43) Date of publication of application: 29.08.2018
(73) Proprietor: Commsolid GmbH, 01099 Dresden (DE)
(72) Inventor: Bury, Andreas, 01099 Dresden (DE)
(74) Representative: Lippert Stachow Patentanwälte Rechtsanwälte Partnerschaft mbB

(56) References cited:
- WO-A1-2016/182901
- US-B1- 7 365 667
- US-B1- 7 382 300
- PERTIJS M A P ET AL: "A CMOS Smart Temperature Sensor With a 3 sigma Inaccuracy of +/- 0.1 C From -55C to 125C", IEEE JOURNAL OF SOLID-STATE CIRCUITS, IEEE SERVICE CENTER, PISCATAWAY, NJ, USA, vol. 40, no. 12, 12 December 2005 (2005-12-12), pages 2805-2815, XP002619906, ISSN: 0018-9200, DOI: 10.1109/JSSC.2005.858476 [retrieved on 2005-12-05]
- PO-CHIAO LEE ET AL: "Incremental delta-sigma A/D converter for ion-sensitive system application", CIRCUITS AND SYSTEMS (APCCAS), 2010 IEEE ASIA PACIFIC CONFERENCE ON, IEEE, 6 December 2010 (2010-12-06), pages 1035-1038, XP031875769, DOI: 10.1109/APCCAS.2010.5774833 ISBN: 978-1-4244-7454-7

## Description

The invention relates to an analog-to-digital converter using a sigma-delta modulator.

Sigma-delta analog-to-digital converters operate at significant oversampling and employ digital decimation filters to deliver a signal at the required sample rate. Typically, the decimation filter comprises multiple decimation states, e.g., using so-called cascaded integrator comb (CIC) filters, delivering samples spaced equidistantly in time.

In wireless radio transmission it is common to operate at a fixed ratio between carrier frequency and sampling frequency. At the receiver this may be achieved by deriving both the carrier frequency clock as well as the sample clock from a common reference oscillator. Given that the carrier frequency value is known at the receiver, by tuning the carrier frequency offset to zero via reference oscillator frequency change, it is also possible to exactly meet the correct sampling frequency. This holds exactly in static scenarios without distance change between transmitter and receiver and typically good enough in mobile scenarios. Alternatively to tuning a common reference oscillator, a fractional re-sampler may take care of sampling frequency correction, which is a dedicated extra functional block.

Furthermore, in baseband receivers for OFDM (Orthogonal Frequency-Division Multiplexing) reception the FFT (fast Fourier transformation) portions related to individual OFDM symbols would be cut out of the signal stream, typically leaving the entire signal processing prior to this point running, including analog-to-digital conversion (ADC) and related decimation filtering, which is mandatory for sigma-delta (SD) type of ADCs. In other words, samples of the discarded cyclic prefixes are actually computed beforehand, which might be regarded as a waste of energy. In the LTE standard a so-called cyclic prefix (CP) is used and inserted into the OFDM symbol in order to obtain a time window of orthogonal data transmission without inter-carrier and inter-symbol interference. Thus, a cyclic prefix is a guard band that is made between the LTE symbols.

The downlink signal format definition for LTE and also narrow-band LTE is compatible to a sampling frequency of 1920 kHz. At this sampling frequency, the so-called "normal cyclic prefix" has a duration of either 9 or 10 samples, respectively for certain OFDM symbols. Lower sampling frequencies result in a fractional sample spacing. Standard multi-mode receivers for LTE Cat-M and narrow-band LTE would operate at 1920 kHz in both modes and use a partial FFT in case of narrowband LTE operation, which is suboptimum with respect to power efficiency.

The narrowband LTE downlink signal utilizes a bandwidth of 180 kHz. Using a sampling frequency as low as 240 kHz it is desirable to achieve a low power consumption. However, when using equidistant sampling at this rate, the cyclic prefixes have non-integer sample durations.

Therefore, it is desirable to have a simple decimation filter which can insert pauses of non-integer numbers of samples.

So, it is desirable to save energy during time gaps when no received sample is needed.

Although, a crystal oscillator without voltage control achieves better phase noise performance compared to a controllable counterpart, which is desirable when targeting the highest coverage class, where operation at very low signal-to-noise-ration (SNR) requires coherent combining across long signal durations. Coverage classes are defined for different maximum supported signal attenuation between transmitter and receiver. For example, the highest coverage class is the one supporting 164 dB of attenuation between base station and user equipment antennas. However, when using such type of oscillator, the sampling frequency can no longer be locked to the radio frequency. Some means of fractional resampling helps to lock the sampling clock to the carrier frequency. Such means is for example a fractional re-sampler consisting of a polyphase filter and a linear interpolator.

So, a simple analog-to-digital converter that can realize and satisfy the above requirements is wanted.

Patent application US 7 365 667 B1 by NANDA KARTIK [US] ET AL, discloses a sigma-delta analog-to-digital converter that is powered down when no output samples are requested.

The objective of the invention will be solved by an analog-to-digital converter as set forth by the appended independent claims.

And in an embodiment of the invention a sigma-delta modulator power control unit powers on or off the sigma-delta modulator according to a next digital sample request.

In another further embodiment of the invention an RF power control unit powers on or off the RF receiver chain or part of the RF receiver chain according to a next digital sample request. A part of the receiver chain could be a low noise amplifier (LNA), a mixer, a local oscillator (LO) comprising a phase-locked-loop (PLL) or a variable gain amplifier (VGA), all of them or only parts or single components of the receiver chain can be powered on or off.

And in another embodiment not forming part of the invention, the decimation is split into a pre-decimation followed by the decimation method described above.

In other words, the proposed analog-to-digital converter comprises the following: A one-step decimation from the high sigma-delta modulator output sampling frequency to the receiver input sampling frequency should be performed. Thus, each output sample is computed as a weighted sum over a range of input samples, corresponding to the filter length. The choice of the sigma-delta modulator sampling frequency should be a sufficiently large multiple of all supported receiver input sample frequencies, such that a sufficiently large output signal-to-noise ratio (SNR) by means of noise shaping and subsequent (one-step decimation) filtering will be achieved. In a receiver application, the receiver would request filtered samples either equidistantly spaced, e.g., one output sample every K input samples or non-equidistantly spaced, e.g., when inserting a time gap to discard the OFDM cyclic prefix. So, there is a possibility to select the time position for decimator output sample computation at time granularity of the much higher input sample frequency. There are also means to determine time intervals where no input sample to the decimator is needed, and further controlling means to power off the sigma-delta modulator circuitry. A sample-computation-trigger unit is such a mean that is connected to the next-sample-time-computation unit configured to compare an actual sample-time-counter value with the sample-time-counter value when the next digital output sample is requested, whereas the sample-computation-trigger unit triggers a sigma-delta modulator power control unit, an output-compute-counter unit as well as an output-sample accumulator in dependence of a difference between the actual sample-time-counter value and the next sample-time-counter value. Background is that around each decimator output sample, a number of input samples must be available to support the length of the decimation filter. A power switch is controlled by the result of comparing a sample-time-counter operating at the high rate against the time window required to compute an output sample (filter response duration plus sigma delta modulator settling time). As long as the time distance from sample to sample is shorter than the time window duration, the switch will keep the circuitry powered on. Furthermore, there are means to artificially move the point of time of output sample computation by +/-1 input sample of time, in order to tune the output sampling frequency to compensate for sample frequency offset. The background is that an equidistant sampling at a spacing of K input samples produces a fixed sampling rate. By duplicating one input sample every N output samples, the average sample spacing decreases from "every K input samples" to "every K-(1/K/N)". Vice versa, by removing one input sample every N output samples, the average sample spacing increases from "every K input samples" to "every K+(1/K/N)". The means to achieve this is a sample counter and the possibility to either skip or duplicate an input sample. There is also a decimator control circuitry to request portions of equidistantly sampled output signal separated by arbitrarily selected time gaps. The circuitry has to be implemented once in a decimator for complex in-phase (I) and quadrature phase (Q) signals, and for the case of multiple receive antennas. All may be shared, except the sample computation path consisting of the sigma-delta modulator, sample buffer, sample multiplier and output sample accumulator. By this a very flexible and easily adapted solution achieves very low power consumption and small silicon area.

In further embodiments of the invention the sigma-delta modulator is a single-bit or a multi-bit and/or a continuous-time or discrete-time and/or a bandpass or baseband sigma-delta modulator. The type is selectable in dependence of the application. A sample clock controls the sigma-delta modulator and a sample-time-counter. The digital output values of the sigma-delta modulator are stored in a sample buffer, under control of the sample-time-counter.

In another embodiment the next-sample-time-computation unit is activated by a request format starting at time point t and consisting in delivering N samples of equidistant spacing T and time ticks of the sample clock. Meaning that a sample computation request asks for digital output samples to be computed at certain values of the sample time counter by using a simple format of such a request that consists in delivering N samples of equidistant spacing T time ticks of the sample clock. More complex, implementation specific request formats are possible, e.g., to skip the cyclic prefix in OFDM, or to obtain a non-integer sampling frequency ratio.

The next-sample-time-computation unit computes the sample time counter value when the next output sample is requested. For equidistant sampling, the next sample time is the current sample time plus an offset K. In OFDM, a one-time larger offset, e.g., NCP*K, may be used to skip the cyclic prefix, in which case the sigma-delta modulator may get powered off.

The sample-computation-trigger unit serves two purposes, both based upon comparing the actual sample time counter value with the sample time counter value when the next sample is requested: If the delta of the two values falls below the filter length, it requests the sigma-delta modulator power Control to turn on the sigma-delta modulator, and if the values match, it triggers computation of the next output sample. So in a preferred embodiment the sample-computation-trigger unit powers on the sigma-delta modulator if the difference of the instantaneous sample-time-counter value and the sample-time-counter value when the next digital output sample is requested falls below a filter length.

In the present invention the sample-computation-trigger unit triggers the computation of the next digital output sample if the actual sample-time-counter value and the sample-time-counter value when the next digital output sample is requested matches.

In an embodiment of the invention the sample-time-counter value is a current sampling time plus an offset K.

And in a preferred embodiment a one-time larger offset is used to skip a portion of the signal, in which case the sigma-delta modulator is powered off. Multiple sample requests will be configured, supporting cases where the time delta between the last sample of request 0, t₀+(K₀-1)*T₀, and the 1st sample of request 1, t₁, is different from T₀.

Also, request 1 may use a sample period T₁ which is distinct from T₀.

In a further embodiment a shape of the filter is varied by a change of coefficients stored in the filter coefficient memory and a length of the filter. The proposed solution supports simple variation of the filter shape by change of coefficients and length of the filter itself.

The proposed solution for power control of the sigma-delta modulator can also be extended further, beyond control of the sigma-delta modulator, e.g., to control a radio frequency mixer, low noise amplifier and further amplification stages. So it can be used in low power receivers, e.g., in modems for sensor networks or modems employing energy harvesting.

The objective of the invention will be also solved by a method for converting an analog signal into a digital signal using the analog-to-digital converter according to claims 1 to 10, wherein the method comprises the following steps:
- using a sigma-delta modulator to produce a quantized, noise-shaped signal at a large sampling frequency,
- delivering output samples at requested output time positions when samples are used for a computed decimator output sample by computing weighted sums over appropriate ranges of input samples according to the filter length,
- optionally powering off the sigma-delta modulator in intervals when no filtered sample is requested and used for a computed decimator output sample in an off-period.

With other words the method uses an one-step decimation filtering from a high sigma-delta modulator output sampling frequency to a lower receiver input sampling frequency by computing weighted sums over ranges of input samples according to the filter length, whereas the output sample times and thus the associated ranges of input samples are determined as requested via configuration, N samples of equidistant spacing T starting at time t.

In a preferred embodiment of the inventive method a baseband receiver requests the filtered samples equidistantly spaced or non-equidistantly spaced, whereas the sigma-delta modulator as well as other components of the RF side can be powered off when no sample is requested in order to save energy and to reduce the overall power consumption.

The invention will be explained in more detail using an exemplary embodiment.

The appended drawing shows
- Fig. 1: Schematical drawing of a timeline, with on-and off- periods and where samples are requested in the on-period and no samples are requested in the off-period;
- Fig. 2: An analog-to digital converter with the inventive extension of the computation unit;
- Fig. 3: An analog-to digital converter of fig. 2 with a detailed view of the computation unit;
- Fig. 4: An analog-to digital converter with an optional RF path for power control and an optional predecimation filter to minimize overall decimation filtering complexity and power consumption.

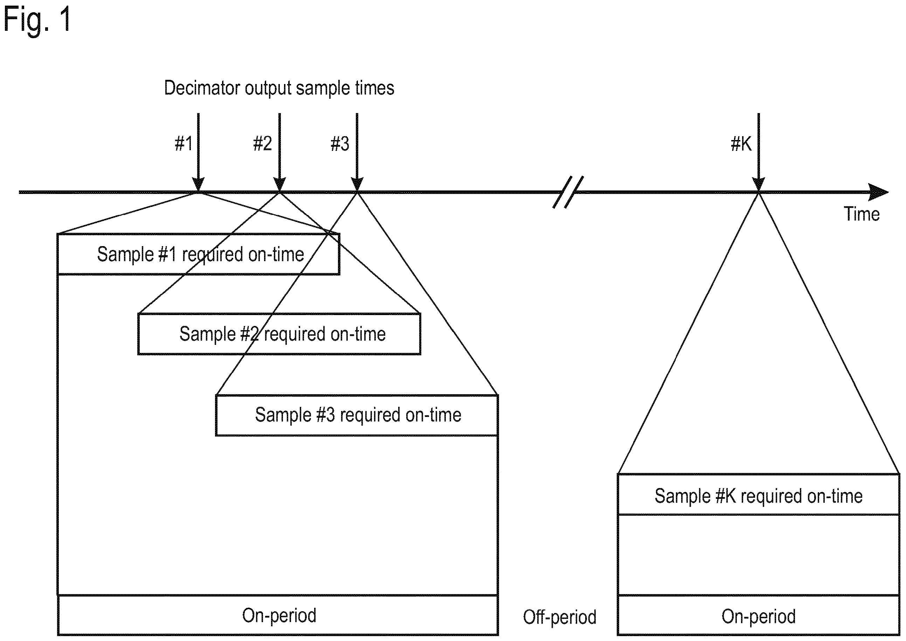

Figure 1 shows a timeline with on- and off- periods, whereas samples are requested in the on-period. In the off-period no samples are requested. In such off-periods it is possible to power off the sigma-delta modulator 1 and other components of the RF side, because they are not needed when no samples are requested. This results in saving energy and a reduction in the overall power consumption. With the inventive analog-to-digital converter it is possible to request output samples at any time, meaning at an arbitrary point in time whenever it is desired. An advantage is that this is not restricted to equidistant time positions as with standard A/D converters.

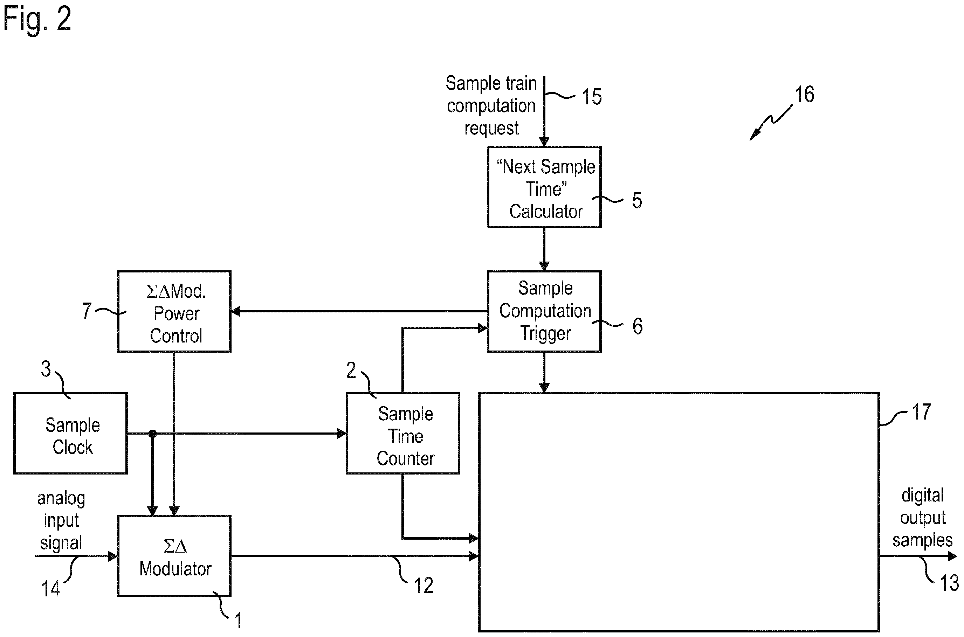

Figure 2 shows an analog-to-digital converter 16 which receives a continuous-time analog signal 14 and delivers a discrete-time digital signal 13. A sample clock 3 controls the sigma-delta modulator 1 and a sample time counter 2. The samples are put out by the computation unit 17 whenever the comparison of the actual sample-time-counter value with the sample-time-counter value when the next sample is requested matches, meaning when the delta of the two values is zero. So, the sigma-delta modulator power control 7 turns on the sigma-delta modulator 1, if the delta of the two values falls below a filter length of the computation unit 17, and if the values match, it triggers the computation of the next output sample.

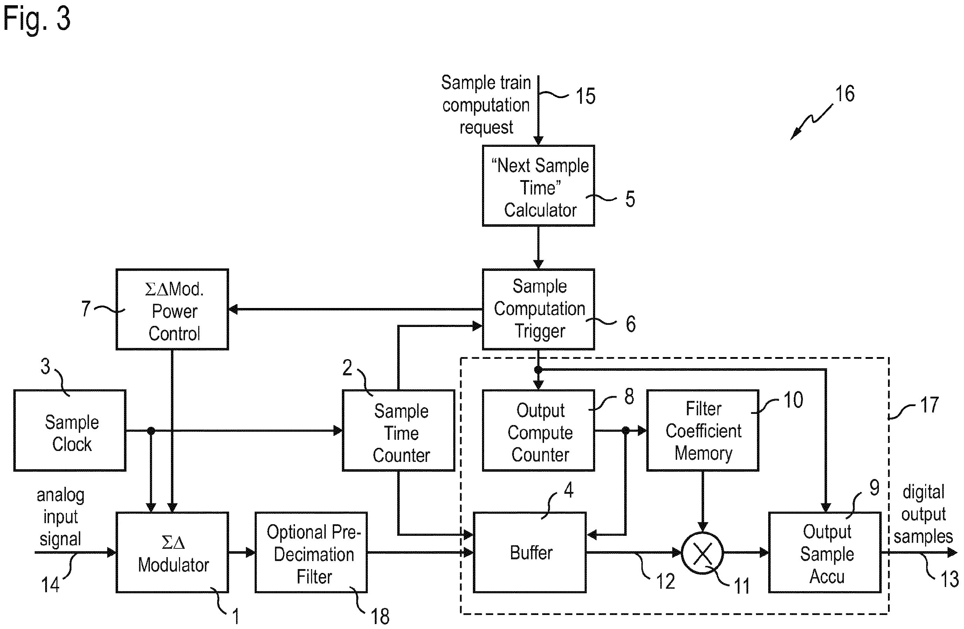

Figure 3 shows the analog-to-digital converter 16 with a possible embodiment of the computation unit 17. Figure 3 shows an analog-to-digital converter 16 which receives a continuous-time analog signal 14 and delivers a discrete-time digital signal 13. A sample clock 3 controls the sigma-delta modulator 1 and a sample time counter 2. Furthermore, the sigma-delta modulator can be connected to an optional pre-decimation filter 18. Inserting a simple pre-decimation filter 18 allows minimizing the overall implementation complexity and power consumption of the decimation filter as a whole. The digital output values 12 of the sigma-delta modulator 1 are stored in a sample buffer 4, under control of the sample time counter 2. A sample computation request 15 asks for digital output samples 13 to be computed at certain values of the sample-time-counter 2. A simple format of such a request consists in delivering N samples of equidistant spacing T time ticks of the sample clock. More complex, implementation specific request formats are possible, e.g., to skip the cyclic prefix in OFDM, or to obtain a non-integer sampling frequency ratio. The next-sample-time-computation unit 5 computes the sample-time-counter value when the next output sample is requested. For equidistant sampling, the next sample time is the current sample time plus an offset K. In OFDM, a one-time larger offset, e.g., NCP*K, may be used to skip the cyclic prefix, in which case the sigma-delta converter may get powered off. The sample-computation-trigger unit 6 serves two purposes, both based upon comparing the actual sample-time-counter value with the sample-time-counter value when the next sample is requested: If the delta of the two values falls below the filter length, it requests the sigma-delta modulator power control 7 to turn on the sigma-delta modulator 1, and if the values match, it triggers computation of the next output sample. The actual output sample computation consists in reading the filter impulse response sample by sample from the filter coefficient memory 10 and accumulating 9 after multiplication 11 with the related sample value read from the buffer 4, given that each output sample is a weighted sum over a set of input samples stored in the sample buffer 4.

The sigma-delta modulator 1 could be single-bit or multi-bit, continuous-time or discrete-time, baseband or bandpass sampling of any order. Compared to related art, the proposed solution requires only a small amount of logic to implement the required functionality, it is able to perform the required functionality at very low power consumption, it offers versatile use, and it supports simple variation of the filter shape by change of coefficients and length of the computation unit 17.

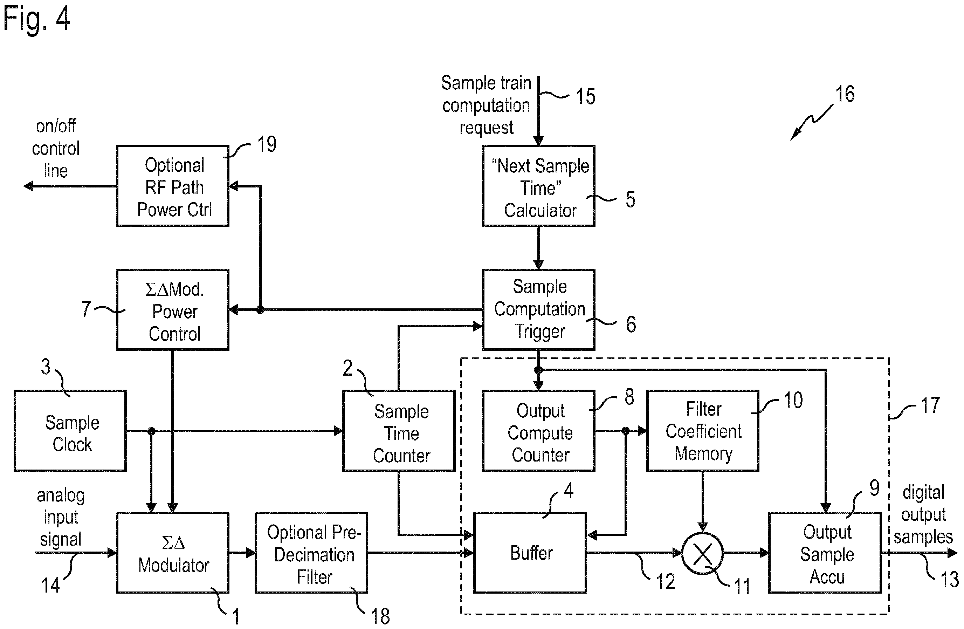

Figure 4 shows another embodiment of the invention. The analog-to-digital converter can additionally comprise an optional RF path power control unit which is triggered by the sample-computation trigger unit 6 and is used to power on or off the entire RF receive path, or parts of the RF receive path.

### Reference signs

- 1: sigma-delta modulator
- 2: sample-time-counter
- 3: sample clock
- 4: sample buffer
- 5: next-sample-time-computation unit
- 6: sample-computation-trigger unit
- 7: sigma-delta modulator power control unit
- 8: output-compute-counter unit
- 9: output-sample accumulator
- 10: filter coefficient memory
- 11: multiplication
- 12: digital output value of the sigma-delta modulator
- 13: digital output samples
- 14: analog input signal
- 15: sample computation request
- 16: analog-to-digital converter
- 17: computation unit
- 18: pre-decimation filter
- 19: RF path power control unit

## Claims

1. Analog-to-digital converter (16) comprising a sigma-delta modulator (1) and a sample-time-counter (2), both controlled by a sample clock (3), a next-sample-time computation unit (5) configured to compute a sample-time-counter value indicating the sample time when a next digital output sample (13) is requested, a sample-computation-trigger unit (6) connected to the sample-time-counter (2) and to the next-sample-time computation unit (5) configured to compare an instantaneous sample-time-counter value with the sample-time-counter value provided by the next-sample-time computation unit (5) and to trigger a computation unit (17) for calculating and outputting a next digital sample when the instantaneous sample-time-counter value and the sample-time-counter value provided by the next-sample-time computation unit matches, whereas the computation unit (17) comprises a sample buffer (4) configured to store digital output values (12) of the sigma-delta modulator (1) under control of the sample time counter (2) and an output-compute-counter unit (8) configured to address corresponding related indices from a filter coefficient memory (10) and the sample buffer (4), and an output-sample accumulator (9), whereas the output-compute-counter unit (8) and output-sample accumulator (9) are triggered if the instantaneous sample-time-counter value and the sample-time-counter value computed by the next-sample-time computation unit (5) match, whereas the output-sample accumulator (9) is configured to compute digital output samples (13) as weighted sums accumulated over a range of samples of the sigma-delta modulator (1) read from the buffer (4) as digital output values (12) and multiplied with respective filter coefficients read sample by sample from the filter coefficient memory (10) .

2. Analog-to-digital converter (16) according to claim 1, wherein a sigma-delta modulator power control unit (7) powers on or off the sigma-delta modulator (1) according to a next digital sample request.

3. Analog-to-digital converter (16) according to claim 1, wherein an RF power control unit powers on or off the RF receiver chain or a part of the RF receiver chain according to a next digital sample request.

4. Analog-to-digital converter according to claim 1, wherein the sigma-delta modulator (1) is a single-bit or a multi-bit and/or a continuous-time or discrete-time and/or a bandpass or baseband sigma-delta modulator (1).

5. Analog-to-digital converter according to claim 1, wherein the next-sample-time-computation unit (5) is activated by a request for delivering N samples of equidistant spacing T starting at time point t.

6. Analog-to-digital converter according to one of the former claims, wherein the sample-computation-trigger unit (6) powers on the sigma-delta modulator (1) if the difference of the actual sample-time-counter value and the sample-time-counter value when the next digital output sample (13) is requested, falls below a threshold value.

7. Analog-to-digital converter according to one of the former claims, wherein the sample-computation-trigger unit (6) triggers the computation of the next digital output sample (13) if the instantaneous sample-time-counter value and the sample-time-counter value when the next digital output sample is requested, matches.

8. Analog-to-digital converter according to one of the former claims, wherein the sample-time-counter value is a current sampling time plus an offset K.

9. Analog-to-digital converter according to the forgoing claim, wherein an one-time larger offset is used to skip a portion of the signal, in which case the sigma-delta modulator (1) is powered off.

10. Analog-to-digital converter according to one of the former claims, wherein a shape of the filter (17) is varied by a change of coefficients stored in the filter coefficient memory (10) and a length of the filter (17).

11. Method for converting an analog signal into a digital signal using the analog-to-digital converter according to claims 1 to 10, wherein the method comprises the following steps:
- using a sigma-delta modulator to produce a quantized, noise-shaped signal at a large sampling frequency,
- delivering output samples at requested output sample time positions when samples are used for a computed decimator output sample by computing weighted sums over appropriate ranges of input samples according to the filter length,
- optionally powering off the sigma-delta modulator in intervals when no filtered sample is requested and used for a computed decimator output sample in an off-period.

12. Method for converting an analog signal into a digital signal according to claim 11, wherein the method comprises the step that an receiver radio frequency path, or part of a receiver radio frequency path prior to the sigma-delta modulator are powered off.

13. Method for converting an analog signal into a digital signal according to claim 12, wherein a receiver requests the filtered samples equidistantly spaced or non-equidistantly spaced.

## Patentansprüche

1. Analog/Digital-Wandler (16), der einen Sigma-Delta-Modulator (1) und einen Abtastzeitpunktzähler (2), die beide durch einen Abtasttakt (3) gesteuert werden, eine Einheit (5) zum Berechnen des Zeitpunkts der nächsten Abtastung, die konfiguriert ist, einen Wert des Abtastzeitpunktzählers zu berechnen, der den Abtastzeitpunkt angibt, an dem eine Abtastung (13) der nächsten digitalen Ausgabe angefordert ist, und eine Einheit (6) zum Auslösen einer Abtastungsberechnung, die mit dem Abtastzeitpunktzähler (2) und mit der Einheit (5) zum Berechnen des Zeitpunkts der nächsten Abtastung verbunden ist und konfiguriert ist, einen momentanen Wert des Abtastzeitpunktzählers mit dem Wert des Abtastzeitpunktzählers, der durch die Einheit (5) zum Berechnen des Zeitpunkts der nächsten Abtastung bereitgestellt ist, zu vergleichen und eine Berechnungseinheit (17) zum Berechnen und Ausgeben einer nächsten digitalen Abtastung auszulösen, wenn der momentane Wert des Abtastzeitpunktzählers und des Werts des Abtastzeitpunktzählers, der durch die Einheit zum Berechnen des Zeitpunkts der nächsten Abtastung übereinstimmt, umfasst, wobei die Berechnungseinheit (17) einen Abtastpuffer (4), der konfiguriert ist, digitale Ausgabewerte (12) des Sigma-Delta-Modulators (1) unter der Steuerung des Abtastzeitpunktzählers (2) und einer Zähleinheit (8) zur Ausgabeberechnung, die konfiguriert ist, entsprechende bezügliche Indizes aus einem Filterkoeffizientenspeicher (10) und dem Abtastpuffer (4) zu adressieren, zu speichern, und einen Sammler (9) für die Ausgabeabtastung umfasst, wobei die Zähleinheit (8) zur Ausgabeberechnung und der Sammler (9) für die Ausgabeabtastung ausgelöst werden, falls der momentane Wert des Abtastzeitpunktzählers und der Wert des Abtastzeitpunktzählers, der durch die Einheit (5) zum Berechnen des Zeitpunkts der nächsten Abtastung berechnet wird, übereinstimmen, wobei der Sammler (9) für die Ausgabeabtastung konfiguriert ist, digitale Ausgabeabtastungen (13) als gewichtete Summen, die über einen Bereich von Abtastungen des Sigma-Delta-Modulators (1), die als digitale Ausgabewerte (12) aus dem Puffer (4) gelesen werden, gesammelt werden und mit jeweiligen Filterkoeffizienten, die Abtastung für Abtastung aus dem Filterkoeffizientenspeicher (10) gelesen werden, multipliziert werden, zu berechnen.

2. Analog/Digital- Wandler (16) nach Anspruch 1, wobei eine Einheit (7) zum Steuern der Leistung des Sigma-Delta-Modulators den Sigma-Delta-Modulator (1) gemäß einer Anforderung der nächsten digitalen Abtastung ein-oder ausschaltet.

3. Analog/Digital- Wandler (16) nach Anspruch 1, wobei eine RF-Leistungssteuereinheit die RF-Empfängerkette oder einen Teil der RF-Empfängerkette gemäß einer Anforderung der nächsten digitalen Abtastung ein- oder ausschaltet.

4. Analog/Digital- Wandler nach Anspruch 1, wobei der Sigma-Delta-Modulator (1) ein Einzel-Bit- oder Multi-Bit- und/oder ein zeitkontinuierlicher oder zeitdiskreter und/oder ein Bandpass- oder Basisband-Sigma-Delta-Modulator (1) ist.

5. Analog/Digital- Wandler nach Anspruch 1, wobei die Einheit (5) zum Berechnen des Zeitpunkts der nächsten Abtastung durch eine Anforderung zum Liefern von N Abtastungen mit einem äquidistantem Abstand T, die bei einem Zeitpunkt t beginnen, aktiviert wird.

6. Analog/Digital- Wandler nach einem der vorhergehenden Ansprüche, wobei die Einheit (6) zum Auslösen einer Abtastungsberechnung den Sigma-Delta-Modulator (1) einschaltet, falls die Differenz des aktuellen Werts des Abtastzeitpunktzählers und des Werts des Abtastzeitpunktzählers, wenn die nächste digitale Ausgabeabtastung (13) angefordert wird, unter einen Schwellenwert fällt.

7. Analog/Digital- Wandler nach einem der vorhergehenden Ansprüche, wobei die Einheit (6) zum Auslösen einer Abtastungsberechnung die Berechnung der nächsten digitalen Ausgabeabtastung (13) auslöst, falls der momentane Wert des Abtastzeitpunktzählers und der Wert des Abtastzeitpunktzählers, wenn die nächste digitale Ausgabeabtastung angefordert wird, übereinstimmt.

8. Analog/Digital- Wandler nach einem der vorhergehenden Ansprüche, wobei der Wert des Abtastzeitpunktzählers ein aktueller Abtastzeitpunkt plus ein Versatz K ist.

9. Analog/Digital- Wandler nach dem vorhergehenden Anspruch, wobei ein einmalig größerer Versatz verwendet wird, um einen Abschnitt des Signals zu überspringen, wobei der Sigma-Delta-Modulator (1) in diesem Fall ausgeschaltet ist.

10. Analog/Digital- Wandler nach einem der vorhergehenden Ansprüche, wobei eine Form des Filters (17) durch eine Änderung von Koeffizienten, die in dem Filterkoeffizientenspeicher (10) gespeichert sind, und eine Länge des Filters (17) variiert wird.

11. Verfahren zum Wandler eines analogen Signals in ein digitales Signal unter Verwendung des Analog/DigitalWandlers nach Anspruch 1 bis 10, wobei das Verfahren die folgenden Schritte umfasst:
- Verwenden eines Sigma-Delta-Modulators, um ein quantisiertes, rauschgeformtes Signal mit einer hohen Abtastfrequenz zu erzeugen,
- Liefern von Ausgabeabtastungen zu angeforderten Zeitpositionen von Ausgabeabtastungen, wenn Abtastungen für eine berechnete Dezimatorausgabeabtastung durch Berechnen von gewichteten Summen über geeignete Bereiche von Eingabeabtastungen gemäß der Filterlänge verwendet werden,
- optionales Ausschalten des Sigma-Delta-Modulators in Intervallen, wenn keine gefilterte Abtastung angefordert ist und für eine berechnete Dezimatorausgabeabtastung in einer Aus-Periode verwendet wird.

12. Verfahren zum Wandeln eines analogen Signals in ein digitales Signal nach Anspruch 11, wobei das Verfahren den Schritt umfasst, dass ein Empfängerfunkfrequenzweg oder ein Teil eines Empfängerfunkfrequenzwegs vor dem Sigma-Delta-Modulator ausgeschaltet ist.

13. Verfahren zum Wandeln eines analogen Signals in ein digitales Signal nach Anspruch 12, wobei ein Empfänger die gefilterten Abtastungen anfordert, die mit äquidistantem oder nicht-äquidistantem Abstand angeordnet sind.

## Revendications

1. Convertisseur analogique-numérique (16) comprenant un modulateur sigma-delta (1) et un compteur de temps d'échantillonnage (2), tous deux commandés par une horloge d'échantillonnage (3), une unité de calcul de temps d'échantillonnage suivant (5) configurée pour calculer une valeur de compteur de temps d'échantillonnage indiquant le temps d'échantillonnage lorsqu'un échantillon de sortie numérique suivant (13) est demandé, une unité de déclenchement de calcul d'échantillon (6) connectée au compteur de temps d'échantillonnage (2) et à l'unité de calcul de temps d'échantillonnage suivant (5) configurée pour comparer une valeur de compteur de temps d'échantillonnage instantané à la valeur de compteur de temps d'échantillonnage fournie par l'unité de calcul de temps d'échantillonnage suivant (5) et pour déclencher une unité de calcul (17) pour calculer et fournir en sortie un échantillon numérique suivant lorsque la valeur de compteur de temps d'échantillonnage instantané et la valeur de compteur de temps d'échantillonnage fournie par l'unité de calcul de temps d'échantillonnage suivant correspondent, dans lequel l'unité de calcul (17) comprend un tampon d'échantillons (4) configuré pour stocker des valeurs de sortie numériques (12) du modulateur sigma-delta (1) sous le contrôle du compteur de temps d'échantillonnage (2) et une unité de comptage de calcul de sortie (8) configurée pour adresser des indices liés correspondants provenant d'une mémoire de coefficients de filtre (10) et du tampon d'échantillons (4), et un accumulateur d'échantillons de sortie (9), dans lequel l'unité de comptage de calcul de sortie (8) et l'accumulateur d'échantillons de sortie (9) sont déclenchés si la valeur de compteur de temps d'échantillonnage instantanée et la valeur de compteur de temps d'échantillonnage calculée par l'unité de calcul de temps d'échantillonnage suivant (5) correspondent, dans lequel l'accumulateur d'échantillons de sortie (9) est configuré pour calculer des échantillons de sortie numériques (13) sous la forme de sommes pondérées accumulées sur une plage d'échantillons du modulateur sigma-delta (1) lus à partir du tampon (4) sous la forme de valeurs de sortie numériques (12) et multipliés par des coefficients de filtre respectifs lus échantillon par échantillon à partir de la mémoire de coefficients de filtre (10).

2. Convertisseur analogique-numérique (16) selon la revendication 1, dans lequel une unité de commande de puissance de modulateur sigma-delta (7) met sous tension ou hors tension le modulateur sigma-delta (1) selon une demande d'échantillon numérique suivant.

3. Convertisseur analogique-numérique (16) selon la revendication 1, dans lequel une unité de commande de puissance RF met sous tension ou hors tension la chaîne de réception RF ou une partie de la chaîne de réception RF selon une demande d'échantillon numérique suivant.

4. Convertisseur analogique-numérique selon la revendication 1, dans lequel le modulateur sigma-delta (1) est un modulateur sigma-delta (1) à un seul bit ou à bits multiples et/ou à temps continu ou à temps discret et/ou en bande passante ou en bande de base.

5. Convertisseur analogique-numérique selon la revendication 1, dans lequel l'unité de calcul de temps d'échantillonnage suivant (5) est activée par une demande de fourniture de N échantillons d'espacement équidistant T commençant à un point dans le temps t.

6. Convertisseur analogique-numérique selon l'une des revendications précédentes, dans lequel l'unité de déclenchement de calcul d'échantillon (6) active le modulateur sigma-delta (1) si la différence entre la valeur de compteur de temps d'échantillonnage réelle et la valeur de compteur de temps d'échantillonnage lorsque l'échantillon de sortie numérique suivant (13) est demandé s'abaisse en dessous d'une valeur de seuil.

7. Convertisseur analogique-numérique selon l'une des revendications précédentes, dans lequel l'unité de déclenchement de calcul d'échantillon (6) déclenche le calcul de l'échantillon de sortie numérique suivant (13) si la valeur de compteur de temps d'échantillonnage instantanée et la valeur de compteur de temps d'échantillonnage lorsque l'échantillon de sortie numérique suivant est demandé correspondent.

8. Convertisseur analogique-numérique selon l'une des revendications précédentes, dans lequel la valeur de compteur de temps d'échantillonnage est un temps d'échantillonnage actuel plus un décalage K.

9. Convertisseur analogique-numérique selon la revendication précédente, dans lequel un décalage unique plus important est utilisé pour sauter une partie du signal, auquel cas le modulateur sigma-delta (1) est mis hors tension.

10. Convertisseur analogique-numérique selon l'une des revendications précédentes, dans lequel une forme du filtre (17) est amenée à varier par une modification des coefficients stockés dans la mémoire de coefficients de filtre (10) et une longueur du filtre (17).

11. Procédé de conversion d'un signal analogique en un signal numérique au moyen du convertisseur analogique-numérique selon les revendications 1 à 10, dans lequel le procédé comprend les étapes suivantes :
- l'utilisation d'un modulateur sigma-delta pour produire un signal sous forme de bruit quantifié à une fréquence d'échantillonnage élevée,
- la fourniture d'échantillons de sortie à des positions temporelles d'échantillons de sortie demandées lorsque des échantillons sont utilisés pour un échantillon de sortie de décimateur calculé en calculant des sommes pondérées sur des plages appropriées d'échantillons d'entrée selon la longueur du filtre,
- la mise hors tension facultative du modulateur sigma-delta dans des intervalles dans lesquels aucun échantillon filtré n'est demandé et utilisé pour un échantillon de sortie de décimateur calculé au cours d'une période hors tension.

12. Procédé de conversion d'un signal analogique en un signal numérique selon la revendication 11, dans lequel le procédé comprend l'étape de mise hors tension d'un trajet radiofréquence de récepteur, ou d'une partie d'un trajet radiofréquence de récepteur avant le modulateur sigma-delta.

13. Procédé de conversion d'un signal analogique en un signal numérique selon la revendication 12, dans lequel un récepteur demande les échantillons filtrés espacés de manière équidistante ou non équidistante.
